Europäisches Patentamt

(19) European Patent Office    (11) Publication number:    **0 052 414**

Office européen des brevets    **B1**

(12)    **EUROPEAN PATENT SPECIFICATION**

(45) Date of publication of patent specification: **14.11.84**    (51) Int. Cl.³: **G 11 C 19/08**

(21) Application number: **81304284.3**

(22) Date of filing: **17.09.81**

(54) Bubble memory device.

(30) Priority: **06.11.80 US 204728**

(43) Date of publication of application:
**26.05.82 Bulletin 82/21**

(45) Publication of the grant of the patent:
**14.11.84 Bulletin 84/46**

(84) Designated Contracting States:
**DE FR GB**

(56) References cited:
**EP-A-0 031 647**
**FR-A-2 384 322**

**IBM TECHNICAL DISCLOSURE BULLETIN,
volume 22, nr. 12, May 1980 NEW YORK (US)
P.E. BEAULIEU et al.: "Magnetic bubble
memory package", pages 5286-5287
JOURNAL OF APPLIED PHYSICS, volume 42,
nr. 4, 15th March 1971 NEW YORK (US) T.W.
LIU et al.: "Thin-film surface bias on magnetic
bubble materials", pages 1360-1361**

(73) Proprietor: **CONTROL DATA CORPORATION
8100-34th Avenue South
Minneapolis Minnesota 55440 (US)**

(72) Inventor: **Jallen, Gale Allen
1854 Alameda Street
Roseville Minnesota 55113 (US)**
Inventor: **Bonnie, Gene Patrick
2435 E. Old Shakopee
Bloomington Minnesota 55420 (US)**

(74) Representative: **Caro, William Egerton et al
J. MILLER & CO. Lincoln House 296-302 High
Holborn
London WC1V 7JH (GB)**

Courier Press, Leamington Spa, England.

## Description

This invention relates to bubble memory devices.

French Specification No. A 2 384 322 discloses that it is known to reduce the effect of self-demagnetisation at the edges of a permanent magnet by making the magnet thicker at the edges. European Specification No. A 0 031 647 discloses the shaping of a permanent magnet to create a uniform magnetic flux.

Known bubble memory devices require a pair of magnets, each associated with a high permeability levelling plate, within a shielding structure. A bubble memory chip and rotating magnetic field drive coils are located between the pair of magnets. The drive coils are a principal source of heat because of the high frequency resistive losses in the wires that surround the bubble memory chip. The temperature compensation needed by the bubble memory chip (normally the magnets have a similar temperature coefficient) is impeded by the interstitial placement of the levelling plate, causing a temperature gradient between the bubble memory chip and magnets.

Therefore, the present invention seeks to provide a bubble memory device which does not have a high permeability levelling plate and which has a more compact bias field magnet than hitherto.

According to the present invention there is provided a bubble memory device comprising: a magnetic field shielding means; generating means for generating a rotating magnetic field within said magnetic field shielding means; a bubble memory chip; and a magnet for generating a bias magnetic field for said bubble memory chip, characterised in that said magnet consists of a single permanent magnet made of low permeability material and having a first surface in thermal contact with a complementary surface of said bubble memory chip and within said generating means, said magnet having a contoured second surface disposed opposite said first surface so that a central region of the magnet is thicker than an edge region whereby an enhanced magnetic field is created locally and the magnetic field is essentially uniform over the entire bubble memory chip.

Said magnet may be made of barium ferrite or strontium ferrite.

Preferably the first surface of the magnet is substantially flat.

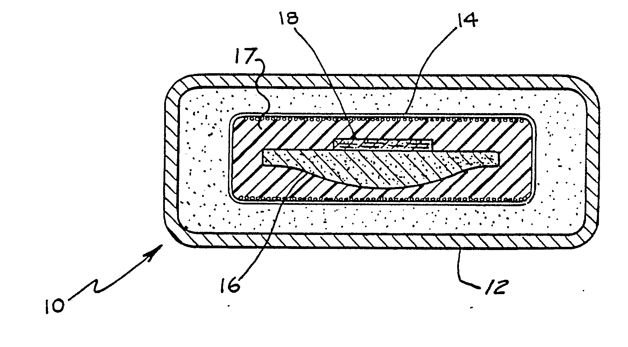

The invention is illustrated, merely by way of example, in the accompanying drawing which is a cross-sectional diagrammatic representation of a bubble memory device 10 according to the present invention.

The bubble memory device 10 has an outer casing 12 of a magnetic field shielding material, for example, to both shield the bubble memory device from external stray magnetic fields and to prevent the emission of magnetic fields from the bubble memory device. A drive coil structure 14, of known construction generates a rotating magnetic field to move magnetic bubbles on a bubble memory chip 18.

A bubble memory bias field magnet 16 is provided in thermal contact with the bubble memory chip 18. The bubble memory chip 18 and the magnet 16 do not necessarily have to be secured or adhered to one another. The casing 12 may be designed to maintain sufficient thermal contact between the magnet 16 and the bubble memory chip 18. A mould 17 of plastics material supports the bubble memory chip 18 and the magnet 16 within the coil structure 14.

The magnet 16 is made of a low permeability material. In particular, the magnet 16 may be made of a ceramic material such as barium ferrite or strontium ferrite having a permeability not much greater than that of air. Alternatively, the magnet 16 may be made of a rubber or plastics material containing magnetic material, such as barium ferrite. In order to prevent self demagnetizing effects from weakening the magnetic field of the magnet 16 in a central region thereof, it is shaped so as to enhance the magnetic field in the central region to compensate for demagnetizing effects.

The contoured surface of the magnet 16 results in a greater thickness or effective length of the magnet in the central region of the magnet. This shaping of the magnet 16 results in an enhanced magnetic field in the central region of the magnet so that the entire magnetic field seen by the bubble memory chip 18 may be comparatively uniform. In addition, the edges of the magnet 16 extend somewhat beyond the edges of bubble memory chip 18 to create a more uniform magnetic field at the edge of the bubble memory chip.

The surface of the magnet 16 in thermal contact with the bubble memory chip 18 is complementary to the adjacent surface of the magnet 16 so as to provide continuous thermal contact between the surfaces. The two surfaces conveniently may be substantially flat. By maintaining the thermal contact between the bubble memory chip 18 and the magnet 16, the stability characteristics of the bubble memory device are enhanced. For example, there is less relative change in magnetic field intensity between the bubble memory chip and the magnet 16 (assuming similar temperature coefficients) and there is little or no relative movement changing the distance between the magnet 16 and the bubble memory chip 18 as a result of expansion or contraction during heating and cooling. In addition, by packaging the magnet 16 and the bubble memory chip in thermal contact, shifting or misalignment of the casing 12 during use and operation could not affect the magnetic field experienced by the bubble memory chip 18. The placing of the magnet 16 in contact with the bubble memory chip 18 permanently establishes the magnetic field strength and eliminates the temperature gradient and distance variables that affects stability.

A particular advantage of the bubble memory device according to the present invention and described above is that the conventional levelling plate for establishing a uniform magnetic field is unnecessary, the magnet 16 can be placed inside the drive coil structure and in thermal contact with the bubble memory chip. The conventional high permeability levelling plate could not be placed within the drive coil structure because of the high heat load generated as a result of hysteresis losses in the high permeability material.

## Claims

1. A bubble memory device comprising: a magnetic field shielding means (12); generating means (14) for generating a rotating magnetic field within said magnetic field shielding means; a bubble memory chip (18); and a magnet (16) for generating a bias magnetic field for said bubble memory chip, characterised in that said magnet consists of a single permanent magnet made of low permeability material and having a first surface in thermal contact with a complementary surface of said bubble memory chip and within said generating means, said magnet having a contoured second surface disposed opposite said first surface so that a central region of the magnet is thicker than an edge region whereby an enhanced magnetic field is created locally and the magnetic field is essentially uniform over the entire bubble memory chip.

2. A bubble memory device as claimed in claim 1 characterised in that said magnet (16) is made of barium ferrite or strontium ferrite.

3. A bubble memory device as claimed in claim 1 or 2 characterised in that the first surface of the magnet is substantially flat.

## Patentansprüche

1. Blasenspeicher mit einer Magnetfeld-Abschirmeinrichtung (12), mit Generatoreinrichtungen (14) zur Erzeugung eines rotierenden Magnetfelds innerhalb des Magnetfed-Abschirmeinrichtung, mit einem Blasenspeicher-Chip (18) und mit einem Magneten (16) zur Erzeugung eines Vorspannmagnetfeldes für den Blasenspeicher-Chip dadurch gekennzeichnet, daß der Magnet aus einem einzigen Permanentmagneten besteht, der aus einem Material niedriger Permeabilität hergestellt ist und eine erste in thermischem Kontakt mit einer komplementären Oberfläche des Blasenspeicher-Chips stehende Oberfläche innerhalb der Generatoreinrichtungen aufweist, daß der Magnet eine der ersten Oberfläche gegenüberliegenden konturierte zweite Oberfläche derart aufweist, daß ein Mittelbereich des Magneten dicker ist als ein Randbereich, so daß ein verstärktes Magnetfeld örtlich erzeugt wird und das magnetfeld über den gesamten Blasenspeicher-Chip im wesentlichen gleichförmig ist.

2. Blasenspeicher nach Anspruch 1, dadurch gekennzeichnet, daß der Magnet (16) aus Bariumferrit oder Strontiumferrit besteht.

3. Blasenspeicher nach Anspruch 1 oder 2, dadurch gekennzeichnet, daß die erste Oberfläche des Magneten im wesentlichen eben ist.

## Revendications

1. Dispositif de mémoire à bulles comprenant un dispositif de blindage (12) contre les champs magnétiques, un dispositif générateur (14) pour créer un champ magnétique tournant dans ce dispositif de blindage, une pastille mémoire à bulles (18) et un aimant (16) pour créer un champ magnétique de polarisation ou de conservation pour la pastille mémoire, caractérisé en ce que l'aimant est formé par un seul aimant permanent d'un matériau à faible perméabilité, qui présente une première surface en contact thermique avec une surface complémentaire de la pastille et située à l'intérieur du dispositif générateur, de même qu'une seconde surface située à l'opposé de la première et qui est profilée de telle manière que la région centrale de l'aimant est plus épaisse que le bord, ce qui produit un renforcement local du champ magnétique et procure un champ magnétique essentiellement uniforme sur toute l'étendue de la pastille mémoire.

2. Dispositif de mémoire à bulles selon la revendication 1, caractérisé en en ce que l'aimant (16) est en ferrite de baryum ou en ferrite de strontium.

3. Dispositif de mémoire à bulles selon la revendication 1 ou 2, caractérisé en ce que la première surface de l'aimant est sensiblement plane.